(19) Europäisches Patentamt
European Patent Office
Office européen des brevets

(11) EP 2 952 939 A1

(12) # EUROPEAN PATENT APPLICATION
published in accordance with Art. 153(4) EPC

(43) Date of publication:
**09.12.2015 Bulletin 2015/50**

(21) Application number: **14745570.3**

(22) Date of filing: **30.01.2014**

(51) Int Cl.:
***G02B 5/26*** (2006.01) ***B32B 9/00*** (2006.01)
***B32B 15/08*** (2006.01) ***C23C 14/06*** (2006.01)
***C23C 14/34*** (2006.01)

(86) International application number:
**PCT/JP2014/052159**

(87) International publication number:
**WO 2014/119683 (07.08.2014 Gazette 2014/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.01.2013 JP 2013017533**
**27.01.2014 JP 2014012215**

(71) Applicant: **Nitto Denko Corporation**
**Ibaraki-shi, Osaka 567-8680 (JP)**

(72) Inventors:
- **WATANABE, Masahiko**
**Ibaraki-shi, Osaka 567-8680 (JP)**
- **OHMORI, Yutaka**
**Ibaraki-shi, Osaka 5678680 (JP)**

(74) Representative: **Jones, Helen M.M.**
**Gill Jennings & Every LLP**
**The Broadgate Tower**
**20 Primrose Street**
**London EC2A 2ES (GB)**

(54) **METHOD FOR PRODUCING INFRARED RADIATION REFLECTING FILM**

(57) The method for manufacturing an infrared reflecting film comprises, in order: a metal layer forming step of depositing a metal layer (25) on a transparent film substrate (10); a metal oxide layer forming step of depositing a surface-side metal oxide layer (22) by DC sputtering on the metal layer (25) so as to be in direct contact with the metal layer (25); and a transparent protective layer forming step of depositing a transparent protective layer (30) on the surface-side metal oxide layer (22). In the metal oxide layer forming step, a sputtering target used for DC sputtering contains zinc atoms and tin atoms, and is preferably formed by sintering a metal powder and at least one metal oxide among zinc oxide and tin oxide. In the surface-side metal oxide layer forming step, an inert gas and an oxygen gas are introduced into a sputtering chamber. The oxygen concentration in the gas introduced to the sputtering chamber is preferably not more than 8 vol%.

FIG. 1

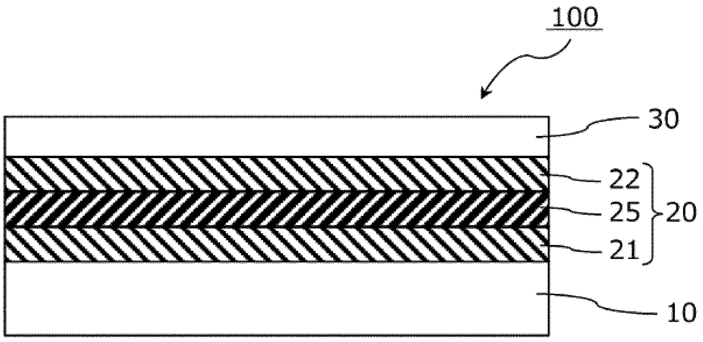




Printed by Jouve, 75001 PARIS (FR)

## Description

### TECHNICAL FIELD

The present invention relates to a method for manufacturing an infrared reflecting film which is mainly used for arranging on an interior side of glass windows or the like.

### BACKGROUND ART

Heretofore, an infrared reflecting substrate having an infrared reflecting layer on a substrate of glass, film or the like is known. As the infrared reflecting layer, an alternative laminate of metal layer(s) and metal oxide layer(s) is widely used. The infrared reflecting layer can have a heat shielding property by reflecting near-infrared rays such as sunlight. As the metal layer, silver or the like is widely used from the viewpoint of enhancing the selective reflectivity of infrared rays, and as the metal oxide layer, an indium-tin composite oxide (ITO) or the like is widely used. These metal layers and metal oxide layers do not have sufficient physical strength such as abrasion-resistance and tend to cause deterioration due to external environment factors such as heat, ultraviolet ray, oxygen and water. Thus, in general, a protective layer is provided on the side opposite to the substrate of the infrared reflecting layer for the purpose of protecting the infrared reflecting layer.

In recent years, an attempt of reducing the emissivity of the infrared reflecting substrate to provide heat insulating properties has been made. In order to reduce the emissivity of the infrared reflecting substrate, it is important that the metal layer in the infrared reflecting layer reflects far-infrared rays toward indoors. However, since a film or a curable resin layer used as a protective layer of the infrared reflecting substrate generally contains many compounds having C=C bonds, C=O bonds, C-O bonds or aromatic rings, infrared vibration absorption of a far-infrared ray region of a wavelength of 5 $\mu$m to 25 $\mu$m is large. The far-infrared rays absorbed at the protective layer is diffused outdoors as heat due to thermal conduction without being reflected at the metal layer. Therefore, when an amount of the far-infrared rays absorbed by the protective layer is large, the emissivity is increased and the heat insulating effect is not achieved.

Patent Document 1 proposes a method in which the thickness of the protective layer is decreased to reduce the amount of the far-infrared rays absorbed by the protective layer for the purpose of reducing the emissivity of the infrared reflecting substrate. On the other hand, when the thickness of the protective layer is decreased, a protecting effect by the protective layer is decreased and therefore the durability of the infrared reflecting layer, particularly, the metal layer tends to deteriorate. In general, if the metal layer is oxidized, the far-infrared absorptivity (emissivity) increases, and this tends to cause deterioration of heat insulating properties or a reduction of the visible light transmittance.

In Patent Document 2, an attempt is made to increase the durability of the infrared reflecting substrate by employing zinc tin oxide (ZTO) as a metal oxide layer constituting the infrared reflecting layer. Since the ZTO has high chemical resistance against acid, alkali and chloride ions, etc., the durability of the infrared reflecting substrate can be increased by forming ZTO as a metal oxide layer on a metal layer such as silver.

Further, a metal oxide layer constituting the infrared reflecting layer generally has insufficient adhesion to a metal layer such as silver, and this is also a factor of deteriorating the durability of the infrared reflecting layer. In Patent Documents 1 and 2, a metal primer layer consisting of Ni-Cr alloy, Ti or the like is disposed between the metal oxide layer and the metal layer in order to secure the adhesion between these layers. However, in order to deposit the metal primer layer between the metal oxide layer and the metal layer, facilities are complicated due to an increase of number of deposition targets used and number of times of deposition for forming an infrared reflecting layer, and this causes a reduction of productivity. Further, low visible light transmittance of the metal such as Ni-Cr may cause a problem of reduction of a visible light transmittance of the infrared reflecting substrate.

### PRIOR ART DOCUMENTS

### PATENT DOCUMENTS

Patent Document 1: WO 2011/109306 A
Patent Document 2: JP 1-301537 A

## SUMMARY OF THE INVENTION

### PROBLEMS TO BE SOLVED BY THE INVENTION

As disclosed in Patent Document 2, the durability of the infrared reflecting layer is expected to be improved even when a thickness of the transparent protective layer is small by employing ZTO as a metal oxide layer constituting the infrared reflecting layer. However, the electrical conductivity of an oxide target for forming ZTO is low, particularly in an Sn-rich ZTO in which tin content is large, and thus it is difficult to perform DC sputtering deposition stably, even though the DC sputtering in general is capable of realizing a high deposition rate. Further, investigations of the present inventors have revealed that when a metal oxide layer composed of ZTO is formed by a reactive sputtering method using a metal target composed of a metal zinc and a metal tin, a metal layer (Ag, etc.) serving as a deposition underlay of ZTO is oxidized by excessive oxygen in a deposition atmosphere and characteristics of the infrared reflecting layer are deteriorated.

Further, it is difficult to deposit ZTO by a DC sputtering method, and effective means of increasing the adhesion between the metal layer and the metal oxide layer has not been found out. Patent Document 2 proposes a method in which a metal primer layer is formed on a glass substrate followed by a thermal treatment at high temperature to oxidize the primer layer, thereby improving the visible light transmittance of the infrared reflecting substrate in addition to an improvement of adhesion by virtue of the primer layer. However, when the transparent resin film substrate is used as a substrate, there is a problem that the film substrate is melted or thermally-deteriorated due to the treatment at high temperature.

As described above, in a conventional technology, reduction of the thickness of the transparent protective layer for the purpose of imparting heat insulating properties to the infrared reflecting film is accompanied by a problem that the durability is deteriorated. Deposition of a primer layer between the metal layer and the metal oxide layer for the purpose of improving durability of the infrared reflecting layer is accompanied by a problem of a reduced productivity or a reduced visible light transmittance. Although ZTO is expected to be effective for improving the durability of the infrared reflecting layer, effective means for imparting improved adhesion with the metal layer and improved productivity to ZTO has not been found out. As just described, a method for providing an infrared reflecting film simultaneously satisfying the productivity, the heat insulating properties, the durability, the visible light transmittance, and the adhesion of the infrared reflecting layer simultaneously is not found out.

### MEANS FOR SOLVING THE PROBLEMS

In view of the above-mentioned current situation, the present inventors made investigations and consequently found that a high deposition rate is realized by depositing ZTO on a metal layer composed mainly of silver by sputtering using a target formed by sintering a metal oxide and a metal powder. In addition, it was found that adhesion between the metal layer and the metal oxide layer is enhanced by depositing ZTO by a specific oxygen introduction amount.

The present invention relates to a method for manufacturing an infrared reflecting film including an infrared reflecting layer having a metal layer and a metal oxide layer, and a transparent protective layer in this order on a transparent film substrate. The metal layer constituting the infrared reflecting layer is composed mainly of silver, and the metal oxide layer is a composite metal oxide layer containing tin oxide and zinc oxide.

The method for manufacturing an infrared reflecting film of the present invention comprises, in order: a metal layer forming step of forming a metal layer on a transparent film substrate; a surface-side metal oxide layer forming step of depositing a surface-side metal oxide layer by DC sputtering on the metal layer so as to be in direct contact with the metal layer; and a transparent protective layer forming step of forming a transparent protective layer on the surface-side metal oxide layer. In an embodiment of the present invention, the transparent protective layer is formed on the metal oxide layer so as to be in direct contact with the metal oxide layer.

In a preferred aspect of the present invention, the method further comprises a substrate-side metal oxide layer forming step of depositing the substrate-side metal oxide layer, which is composed of a composite metal oxide containing tin oxide and zinc oxide, by DC sputtering on the transparent film substrate prior to the metal layer forming step.

In the surface-side metal oxide layer forming step and the substrate-side metal oxide layer forming step, a sputtering target used for DC sputtering contains zinc atoms and tin atoms, and is formed by sintering a metal powder and at least one metal oxide among zinc oxide and tin oxide.

A metal powder used for the formation of the target is preferably metal zinc and/or metal tin. A total of the contents of the metal zinc and the metal tin respectively used for the formation of the target is preferably 0.1 to 20 wt%. A ratio between zinc atoms and tin atoms, respectively contained in the target, is preferably within the range of 10 : 90 to 60 : 40 in terms of an atomic ratio.

In the surface-side metal oxide layer forming step, an inert gas and an oxygen gas are introduced into a sputtering chamber. The oxygen concentration in the gas introduced into the sputtering chamber is preferably 8 vol%

or less. Further, when a composite metal oxide layer containing tin oxide and zinc oxide is formed as a substrate-side metal oxide layer by DC sputtering, the oxygen concentration in the gas introduced into the sputtering chamber is preferably higher than that in the gas introduced into the sputtering chamber in the surface-side metal oxide layer forming step.

## EFFECTS OF THE INVENTION

In the present invention, since ZTO is deposited on the metal layer by DC sputtering method using a specific target, a deposition rate of the metal oxide layer is increased, and therefore the productivity of the infrared reflecting film can be increased. Moreover, the adhesion between the metal layer and the metal oxide layer is enhanced by depositing ZTO by a specific oxygen introduction amount. According to the manufacturing method of the present invention, it is possible to deposit a ZTO metal oxide layer, having excellent durability, with high adhesion on the metal layer composed mainly of silver. Therefore, an infrared reflecting film having high durability is obtained even when a thickness of the transparent protective layer is small.

Further, since the metal oxide layer is formed on the metal layer without forming a primer layer, visible light transmittance of the infrared reflecting film is increased and an improvement of the productivity by virtue of a reduction in the number of stacked layers in the infrared reflecting layer is expected. Moreover, by increasing an oxygen introduction amount in substrate-side metal oxide layer forming step, a visible light transmittance of the infrared reflecting substrate tends to be increased.

## BRIEF DESCRIPTION OF THE DRAWINGS

FIG. 1 is a schematic cross-sectional view showing a stacking configuration of an infrared reflecting film of an embodiment.

FIG. 2 is a schematic cross-sectional view showing a usage example of an infrared reflecting film.

## MODE FOR CARRYING OUT THE INVENTION

FIG. 1 is a schematic cross-sectional view showing a configuration example of an infrared reflecting film. As shown in FIG. 1, an infrared reflecting film 100 includes an infrared reflecting layer 20 and a transparent protective layer 30 in this order on one principal surface of a transparent film substrate 10. The infrared reflecting layer 20 includes a surface-side metal oxide layer 22 on a transparent protective layer 30 side of the metal layer 25. In general, as shown in FIG. 1, a substrate-side metal oxide layer 21 is disposed on a transparent film substrate 10 side of the metal layer 25.

FIG. 2 is a schematic cross-sectional view showing a type of usage of the infrared reflecting film. In this type of usage, a transparent film substrate 10 side of the infrared reflecting film 100 is bonded to a window 50 with an appropriate adhesive layer 60 interposed therebetween and the infrared reflecting film 100 is arranged on an interior side of a window 50 of buildings or automobiles to be used. In this type of usage, a transparent protective layer 30 is arranged on an interior side of the window.

As schematically shown in FIG. 2, the infrared reflecting film 100 transmits visible light (VIS) from the outdoors to introduce the light to the interior, and reflects near-infrared rays (NIR) from the outdoors at the infrared reflecting layer 20. Since heat flow from the outdoors to the interior resulting from sunlight or the like is suppressed (heat shielding effect is exerted) by the reflection of near-infrared rays, efficiency of the air conditioning in summer can be increased. Moreover, since the infrared reflecting layer 20 reflects indoor far-infrared rays (FIR) emitted from a heating appliance 80, a heat insulating effect is exerted and efficiency of heating in winter can be increased.

Hereinafter, materials constituting the respective layers and a method for manufacturing an infrared reflecting film of the present invention will be described.

### [Transparent Film Substrate]

As the transparent film substrate 10, a flexible transparent film is used. As the transparent film substrate, a film having visible light transmittance of 80% or more is suitably used. The visible light transmittance is measured according to JIS A 5759-2008 (Adhesive films for glazings).

The thickness of the transparent film substrate 10 is not particularly limited. Thickness range of about 10 μm to 300 μm is suitable. Further, since there may be cases where high temperature processes are performed in formation of the infrared reflecting layer 20 on the transparent film substrate 10, a resin material constituting the transparent film substrate preferably has excellent heat resistance. Examples of the resin material constituting the transparent film

substrate include polyethylene terephthalate (PET), polyethylene naphthalate (PEN), polyether ether ketone (PEEK), polycarbonate (PC) and the like.

It is preferred that a hard coat layer is disposed on the surface on an infrared reflecting layer 20 formation side of the transparent film substrate 10, for the purpose of increasing the mechanical strength of the infrared reflecting film. The hard coat layer can be formed, for example, by a method in which a cured coating of an appropriate ultraviolet-curable resin, such as acryl-based resin or silicone-based resin, is provided for the transparent film substrate. The hard coat layer with high hardness is suitably used.

For the purpose of increasing the adhesion to the infrared reflecting layer 20, etc., the surface of the transparent film substrate 10 or the surface of the hard coat layer may be subjected to a surface modification treatment such as corona treatment, plasma treatment, flame treatment, ozone treatment, primer treatment, glow treatment, saponification treatment, or treatment with a coupling agent.

[Infrared Reflecting Layer]

An infrared reflecting layer 20 is formed on the transparent film substrate. The infrared reflecting layer 20 has a property of transmitting visible light and reflecting infrared rays, and includes a metal layer and a metal oxide layer. In general, the infrared reflecting layer 20, as shown in FIG. 1, has a configuration in which the metal layer 25 is sandwiched between the metal oxide layers 21 and 22. Although illustrated in FIG. 1 is an infrared reflecting layer 20 having a three-layer structure in which one metal layer 25 is sandwiched between two metal oxide layers 21 and 22, the infrared reflecting layer may have a five-layer structure, for example, metal oxide layer / metal layer / metal oxide layer / metal layer / metal oxide layer. When the number of stacked layers is increased more, for example, five-layer, seven-layer, nine-layer, ..., the wavelength selectivity of the reflectance can be enhanced to increase the reflectance of the near-infrared rays to provide a heat shielding property, and the transmittance of visible light can be increased. On the other hand, from the viewpoint of increasing the productivity, the infrared reflecting layer preferably has a three-layer structure as shown in FIG. 1.

The method for forming an infrared reflecting layer 20 includes a metal layer forming step of forming a metal layer 25; and a surface-side metal oxide layer forming step of depositing a surface-side metal oxide layer 22 by DC sputtering on the metal layer 25 so as to be in direct contact with the metal layer. When a substrate-side metal oxide layer 21 is formed between the transparent film substrate 10 and the metal layer 25, a substrate-side metal oxide layer forming step is provided prior to the metal layer forming step for forming the substrate-side metal oxide layer 21 on the transparent film substrate 10. It is preferred that the substrate-side metal oxide layer 21 is also deposited by DC sputtering in the substrate-side metal oxide layer forming step.

<Metal Layer Forming Step>

The metal layer 25 plays a central role in reflecting infrared rays. In the present invention, a silver alloy layer composed mainly of silver is suitably used as the metal layer 25 from the viewpoint of increasing visible light transmittance and an near-infrared reflectance without increasing the number of stacked layers. Since silver has a high free electron density, it can realize a high reflectance of near-infrared rays and far-infrared rays. Therefore, it is possible to attain an infrared reflecting film which has a high reflectance of the near-infrared rays and far-infrared rays and is excellent in the heat shielding effect and the heat insulating effect even when the number of stacked layers of the infrared reflecting layer is small.

The content of silver in the metal layer 25 is preferably 90 wt% or more, more preferably 93 wt% or more, further preferably 95 wt% or more, and particularly preferably 96 wt% or more. The wavelength selectivity of the transmittance and the reflectance can be enhanced and the visible light transmittance of the infrared reflecting film can be increased by increasing the content of silver in the metal layer.

The metal layer 25 may be a silver alloy layer containing metal other than silver. For example, in order to increase the durability of the metal layer, a silver alloy may be used. As the metal added for the purpose of increasing the durability of the metal layer, palladium (Pd), gold (Au), copper (Cu), bismuth (Bi), germanium (Ge), gallium (Ga) and the like are preferred. Among these metals, Pd is most suitably used from the viewpoint of imparting high durability to silver. When an addition amount of Pd or the like is increased, the durability of the metal layer tends to increase. When the metal layer 25 contains metal such as Pd other than silver, the content of the metal is preferably 0.1 wt% or more, more preferably 0.3 wt% or more, further preferably 0.5 wt% or more, and particularly preferably 1 wt% or more. On the other hand, when the addition amount of Pd or the like is increased and the content of silver is decreased, the visible light transmittance of the infrared reflecting film tends to decrease. Therefore, the content of metal other than silver in the metal layer 25 is preferably 10 wt% or less, more preferably 7 wt% or less, further preferably 5 wt% or less, and particularly preferably 4 wt% or less.

The method for forming the metal layer 25 is not particularly limited. Deposition by a dry process such as a

sputtering method, a vacuum deposition method, a CVD method or an electron-beam deposition method, is preferred. Particularly, in the present invention, it is preferred to perform deposition by the DC sputtering method in the metal layer forming step, as with a deposition of the metal oxide layer described later.

The thickness of the metal layer 25 is appropriately set in consideration of a refractive index of the metal layer, and a refractive index and a thickness of the metal oxide layer so that the infrared reflecting layer transmits visible light and selectively reflects near-infrared rays. The thickness of the metal layer 25 may be set, for example, within the range of 3 nm to 50 nm.

<Surface-Side Metal Oxide Layer Forming Step>

The metal oxide layers 21 and 22 are disposed for the purpose of controlling an amount of reflected visible light at an interface between the metal oxide layer and the metal layer 25 to achieve high visible light transmittance and high infrared reflectance simultaneously. Further, the metal oxide layer can also serve as a protective layer for preventing degradation of the metal layer 25. Particularly, in the present invention, the surface-side metal oxide layer 22 formed on the metal layer 25 coupled with the transparent protective layer 30 can contribute to the prevention of degradation of the metal layer.

From the viewpoint of enhancing the wavelength selectivity of transmission and reflection in the infrared reflecting layer, the refractive indices of the metal oxide layers 21, 22 for visible light are preferably 1.5 or more, more preferably 1.6 or more, and further preferably 1.7 or more. Examples of a material having the above-mentioned refractive index include oxides of metals such as Ti, Zr, Hf, Nb, Zn, Al, Ga, In, Tl and Sn, or composite oxides of these metals.

In the present invention, as the surface-side metal oxide layer 22 formed on the metal layer 25, a composite metal oxide (ZTO) containing zinc oxide and tin oxide is formed. From the viewpoint of improving the productivity and durability of the infrared reflecting layer, it is preferred that the substrate-side metal oxide layer 21 is also ZTO. ZTO is excellent in chemical stability (durability to acid, alkali and chloride ions) and excellent in the adhesion to resin materials or the like constituting a transparent protective layer 30 described later.

Further, as described in detail later, in the present invention, the ZTO is deposited by using a specific target and introducing a specific amount of oxygen, thereby improving the adhesion between the surface-side metal oxide layer 22 and the metal layer 25 to enhance the effect of protecting the metal layer 25. Thus, in the present invention, the surface-side metal oxide layer 22 is deposited so as to be in direct contact with the metal layer 25.

The surface-side metal oxide layer 22 is deposited by a DC sputtering method. Since a deposition rate of DC sputtering method is high, it is possible to improve the productivity of the infrared reflecting film.

For depositing the surface-side metal oxide layer 22, a target containing zinc atoms and tin atoms and formed by sintering a metal powder and at least one metal oxide among zinc oxide and tin oxide, is used. When a material for forming the target contains zinc oxide and does not contain tin oxide, a metal tin powder is contained in the material for forming the target. When the material for forming the target contains tin oxide and does not contain zinc oxide, a metal zinc powder is contained in the material for forming the target. When the material for forming the target contains both of zinc oxide and tin oxide, a metal powder in the material for forming the target may be a powder of metal other than metal zinc and metal tin; however, the material for forming the target preferably contains at least any one among metal zinc and metal tin, and particularly preferably contains metal zinc.

Since zinc oxide and tin oxide (particularly, tin oxide) have low electrical conductivity, a ZTO target formed by sintering only a metal oxide has low electrical conductivity. When such a target is used for DC sputtering, there is a tendency that discharge does not occur or performing deposition stably for a long time is difficult. In contrast, since a target formed by sintering a metal oxide and a metal powder is used in the present invention, the electrical conductivity of the target is improved to stabilize discharge during DC sputtering deposition.

When the amount of a metal used for the formation of the sputtering target is excessively small, sufficient electrical conductivity is not imparted to the target, and therefore deposition by DC sputtering may become unstable. On the other hand, when the content of a metal in the target is excessively large, the amount of a remaining metal unoxidized during the sputtering deposition or the amount of a metal oxide whose oxygen content is less than the stoichiometric composition is increased, and this tends to cause a reduction of visible light transmittance. When the oxygen introduction amount during deposition is increased for the purpose of oxidizing the remaining metal or the metal oxide whose oxygen content is less than the stoichiometric composition, a metal layer (silver, etc.) serving as an underlay for deposition of the metal oxide layer may be oxidized to cause deterioration of infrared-ray reflection characteristics or visible light transmittance. From the above-mentioned viewpoints, the amount of the metal used for the formation of the sputtering target is preferably 0.1 to 20 wt%, more preferably 0.2 to 15 wt%, further preferably 0.5 to 13 wt%, and particularly preferably 1 to 12 wt% in the material for forming a target. Since the metal powder used as a material for the formation of the target is oxidized by sintering, the metal powder may exist as a metal oxide in a sintered target.

A ratio between zinc atoms (Zn) and tin atoms (Sn), respectively contained in the sputtering target used for the deposition of the surface-side metal oxide layer 22, is preferably in the range of 10 : 90 to 60 : 40 in terms of an atomic

ratio. The ratio between Zn and Sn is more preferably in the range of 15 : 85 to 50 : 50, and further preferably in the range of 20 : 80 to 40 : 60. By setting the content of Zn to 10 atom% or more with respect to 100 atom% as a total of Sn and Zn, the electrical conductivity of the target is increased to enable the deposition by DC sputtering, and therefore the productivity of the infrared reflecting film can be further increased. From the viewpoint of improving a deposition property, volume resistivity of the target is preferably 1000 mΩ•cm or less, more preferably 500 mΩ•cm or less, further preferably 300 mΩ•cm or less, particularly preferably 150 mΩ•cm or less, and most preferably 100 mΩ•cm or less.

On the other hand, when the content of Zn is excessively large and the content of Sn is relatively small, this may cause a reduction of the durability of the infrared reflecting layer or a reduction of the adhesion to the metal layer. Therefore, the content of Zn atoms in the target is preferably 60 atom% or less, more preferably 50 atom% or less, and further preferably 40 atom% or less with respect to 100 atom% as a total of Sn and Zn. Zinc atoms contained in the sputtering target are derived from zinc atoms in zinc oxide and the metal zinc powder. Tin atoms contained in the sputtering target are derived from tin atoms in tin oxide and the metal tin powder.

In the present invention, by depositing Sn-rich ZTO in which the content of Sn is large as the surface-side metal oxide layer, the adhesion between the metal layer and the surface-side metal oxide layer is enhanced and the durability of the infrared reflecting layer is improved. Therefore, the content of Sn in the sputtering target is preferably 40 atom% or more, more preferably 50 atom% or more, and further preferably 60 atom% or more with respect to 100 atom% as a total of Sn and Zn. Although the Sn-rich ZTO tends to become low in electrical conductivity, a target formed by sintering a metal oxide and a metal powder as described above is used in the present invention so that the electrical conductivity of the target is improved, and thus Sn-rich ZTO can be deposited by DC sputtering.

The sputtering target used for the deposition of the surface-side metal oxide layer may contain metals such as Ti, Zr, Hf, Nb, Al, Ga, In and Tl, or metal oxides thereof in addition to zinc, tin and oxides thereof. However, an increase in the content of a metal atom other than zinc and tin may cause a reduction of the durability of the infrared reflecting layer or deterioration of transparency. Therefore, the total of the contents of zinc atoms and tin atoms in the sputtering target used for deposition of the surface-side metal oxide layer is preferably 97 atom% or more, and more preferably 99 atom% or more with respect to 100 atom% as a total of metals in the sputtering target.

In the sputtering deposition using the above-mentioned target, it is preferred that at first, inside of the sputtering chamber is evacuated to bring the inside of sputtering apparatus into an atmosphere in which impurities such as water and organic gas generated from the substrate are removed.

After the evacuation, sputtering deposition is performed while introducing an inert gas such as Ar, and oxygen into the sputtering chamber. In the present invention, the amount of oxygen introduced into the deposition chamber in the surface-side metal oxide layer forming step is preferably 8 vol% or less, more preferably 5 vol% or less, and further preferably 4 vol% or less with respect to the total flow rate of the introduced gas. When the oxygen introduction amount is large, the metal layer 25 serving as an underlay of the surface-side metal oxide layer 22 is easily oxidized. The oxygen introduction amount refers to an amount (vol%) of oxygen introduced into a deposition chamber, in which a target to be used for deposition of the surface-side metal oxide layer is placed, with respect to the total amount of the gas introduced into the deposition chamber. When a sputtering deposition apparatus including a plurality of deposition chambers divided by a closure plate is employed, the oxygen introduction amount is calculated based on the amount of gas introduced into each divided deposition chamber.

In the present invention, the adhesion between the surface-side metal oxide layer 22 and the metal layer 25 is enhanced by decreasing the oxygen introduction amount during deposition of the surface-side metal oxide layer 22. The reason why the adhesion between the metal oxide layer and the metal layer is enhanced is not clear, it is estimated that the following contributes to an improvement of the adhesion. Since sputtering is performed under insufficient oxygen condition in which oxygen amount is insufficient for oxidizing a metal in the target to form a metal oxide having stoichiometric composition (zinc oxide (ZnO) and/or tin oxide ($SnO_2$)), obtained metal oxide layer contains a remaining metal or a metal oxide having insufficient oxygen in which the oxygen content is less than the stoichiometric composition.

According to the manufacturing method of the present invention, the number of stacked layers can be reduced to improve the productivity of the infrared reflecting film, since the surface-side metal oxide layer 22 can be deposited directly on the metal layer 25 to impart high adhesion between both layers without disposing a primer layer of Ni-Cr, Ti or the like. Further, the unnecessity of the primer layer can contribute to an improvement of the visible light transmittance.

On the other hand, when the oxygen introduction amount during sputtering deposition is excessively small, an amount of the metal oxide having insufficient oxygen increases, and this tends to cause a reduction of visible light transmittance. Therefore, the amount of oxygen introduced into the deposition chamber during sputtering deposition is preferably 0.1 vol% or more, more preferably 0.5 vol% or more, and further preferably 1 vol% or more with respect to the total flow rate of the introduced gas.

In addition, when the ZTO is deposited by DC sputtering with introduction of a specific amount of oxygen and using the above-mentioned target, there is an advantage that a particle generation (adhesion) on the target during continuous deposition is less than the case of depositing ITO, IZO or the like as a metal oxide. If particles adhere to the surface of the target, abnormal discharge or contamination inside the sputtering apparatus occurs, so that a film with

stable quality is unable to be obtained. Therefore, when particles adhere to the surface of the target, deposition operation is once stopped, and maintenance work such as polishing of the target surface or cleaning of sputtering apparatus, is required. Further, it also takes time to bring the sputtering chamber into vacuum in restarting deposition after the maintenance.

In the present invention, since the adhesion of particles to the target surface during deposition is suppressed and a maintenance interval is lengthened (maintenance frequency is reduced), the production efficiency of the infrared reflecting film can be improved. Particularly, when continuous deposition by a roll-to-roll sputtering apparatus is performed, since maintenance frequency of the sputtering apparatus can be decreased to increase a continuous deposition length, productivity can be outstandingly improved.

A substrate temperature during deposition of the surface-side metal oxide layer 22 by sputtering is preferably lower than a heatresistant temperature of the transparent film substrate. The substrate temperature is preferably, for example, 20°C to 160°C, and more preferably 30°C to 140°C. A power density during sputtering deposition is preferably, for example, 0.1 $W/cm^2$ to 10 $W/cm^2$, more preferably 0.5 $W/cm^2$ to 7.5 $W/cm^2$, and further preferably 1 $W/cm^2$ to 6 $W/cm^2$. A process pressure during deposition is preferably, for example, 0.01 Pa to 10 Pa, more preferably 0.05 Pa to 5 Pa, and further preferably 0.1 Pa to 1 Pa. When the process pressure is excessively high, a deposition rate tends to decrease, and in contrast, when the pressure is excessively low, discharge tends to be unstable.

<Substrate-Side Metal Oxide Layer Forming Step>

A material and deposition conditions of the substrate-side metal oxide layer 21 located on the transparent film substrate 10 side with respect to the metal layer 25 are not particularly limited. ZTO is preferably formed as with the surface-side metal oxide layer 22. When the ZTO is deposited as the substrate-side metal oxide layer, from the viewpoint of improving the productivity, a target formed by sintering a metal oxide and a metal is preferably used as with the metal oxide layer 22.

The composition of a sputtering target used for the formation of the substrate-side metal oxide layer may be similar to the composition of a sputtering target used for the formation of the surface-side metal oxide layer, or may be different from the composition. The amount of the metal used for the formation of the sputtering target is preferably 0.1 to 20 wt%, more preferably 0.2 to 15 wt%, further preferably 0.5 to 13 wt%, and particularly preferably 1 to 12 wt% in the material for forming a target. Further, a ratio between zinc atoms (Zn) and tin atoms (Sn), respectively contained in the sputtering target, is preferably in the range of 10 : 90 to 60 : 40 in terms of an atomic ratio. The ratio between Zn and Sn is more preferably in the range of 15 : 85 to 50 : 50, and further preferably in the range of 20 : 80 to 40 : 60. When composition of the sputtering target is set to the above-mentioned range, a metal oxide layer having an excellent deposition property by DC sputtering and having excellent adhesion to the metal layer 25 is attained.

The amount of oxygen introduced into the deposition chamber in the substrate-side metal oxide layer forming step is not particularly limited, and the amount may be 8 vol% or less as with the surface-side metal oxide layer forming step, or may be more than 8 vol%. The oxygen introduction amount is preferably 8 vol% or less from the viewpoint of enhancing the adhesion between the substrate-side metal oxide layer 21 and the metal layer 25. On the other hand, the oxygen introduction amount can be more than 8 vol% from the viewpoint of reducing the amount of a remaining metal or a metal oxide having insufficient oxygen, thereby improving the visible light transmittance of the metal oxide layer 22.

In an aspect of the manufacturing method of the present invention, the amount of oxygen introduced into the deposition chamber in the substrate-side metal oxide layer forming step is larger than the amount of oxygen introduced into the deposition chamber in the surface-side metal oxide layer forming step. When the oxygen introduction amount (oxygen concentration) during sputtering deposition is large, as described above, the amount of a metal remaining in the substrate-side metal oxide layer or a metal oxide having insufficient oxygen is reduced, thereby increasing the visible light transmittance of the infrared reflecting film.

Further, when the amount of oxygen introduced into the deposition chamber in the substrate-side metal oxide layer forming step is increased, the visible light transmittance is improved, and in addition to this, there are tendencies that coloring of transmitted light and reflected light of the infrared reflecting film is reduced and a hue becomes neutral. Accordingly, visibility of the infrared reflecting film is increased. When the oxygen concentration during formation of the substrate-side metal oxide layer is higher than that during formation of the surface-side metal oxide layer, it is estimated that the following contributes to neutralization of transmitted light and reflected light. Since the substrate-side metal oxide layer 21 has lower oxygen deficiency than the surface-side metal oxide layer 22, this results in differences in wavelength dependency of a refractive index (e.g., Abbe number) and transmission-spectral form of visible light between both layers.

From the viewpoint of increasing the visible light transmittance of the infrared reflecting substrate and neutralizing a hue, the amount of oxygen introduced into the deposition chamber in the substrate-side metal oxide layer forming step is preferably 4 vol% or more, more preferably 6 vol% or more, and further preferably more than 8 vol% with respect to the total flow rate of the introduced gas. Further, the amount of oxygen introduced into the deposition chamber in the substrate-side metal oxide layer forming step is larger preferably by 2 vol% or more, preferably by 4 vol% or more, and

preferably by 6 vol% or more than the amount of oxygen introduced into the deposition chamber in the surface-side metal oxide layer forming step. On the other hand, an introduction of excessively large amount of oxygen during deposition of the substrate-side metal oxide layer may cause a reduction of a deposition rate or a reduction of the adhesion between the substrate-side metal oxide layer 21 and the metal layer 25. Therefore, the amount of oxygen introduced into the deposition chamber in the substrate-side metal oxide layer forming step is preferably 20 vol% or less, and more preferably 15 vol% or less with respect to the total flow rate of the introduced gas.

The thicknesses of the metal oxide layers 21 and 22 are appropriately set in consideration of a refractive index and a thickness of the metal layer, and the number of stacked layers of the infrared reflecting layer so that the infrared reflecting layer 20 transmits visible light and selectively reflects near-infrared rays. The thicknesses of the metal oxide layers can be adjusted, for example, within the range of about 3 nm to 100 nm, preferably within the range of about 5 nm to 80 nm.

As described above, the surface-side metal oxide layer 22 preferably has oxygen content less than the stoichiometric composition, from the viewpoints of increasing the adhesion between the metal layer 25 and the surface-side metal oxide layer 22 and enhancing the durability of the infrared reflecting film. On the other hand, the substrate-side metal oxide layer 21 may have stoichiometric oxygen composition, or may have oxygen content less than the stoichiometric composition. From the viewpoint of increasing the visible light transmittance of the infrared reflecting film and improving a color neutrality of the transmitted light and the reflected light, the substrate-side metal oxide layer is preferably a metal oxide which is larger in the oxygen content than the surface-side metal oxide layer. It is possible to make a difference between the oxygen content of the substrate-side metal oxide layer and the oxygen content of the surface-side metal oxide layer by appropriately adjusting the composition of a target (the content of a metal in a target) used for sputtering deposition or the oxygen introduction amount during deposition.

[Transparent Protective Layer]

A transparent protective layer 30 is provided on the metal oxide layer 22 of the infrared reflecting layer 20 for the purpose of preventing the abrasion or degradation of the infrared reflecting layer. From the viewpoint of enhancing the heat insulating effect by the infrared reflecting film, the far-infrared absorptivity of the transparent protective layer 30 is preferably low. When the far-infrared absorptivity is high, heat insulating properties of the infrared reflecting film tends to decrease since far-infrared rays from the indoor are absorbed in the transparent protective layer and dissipated outdoors due to thermal conduction. On the other hand, when the far-infrared absorptivity of the transparent protective layer 30 is low, the far-infrared rays are reflected indoors by the metal layer 25 of the infrared reflecting layer 20. Therefore, when the far-infrared absorptivity is lower, the heat insulating effect by the infrared reflecting film is higher.

From the viewpoint of reducing the amount of far-infrared absorption to enhance heat insulating properties by the infrared reflecting film, the thickness of the transparent protective layer 30 is preferably 200 nm or less, more preferably 150 nm or less, further preferably 120 nm or less, and particularly preferably 100 nm or less. When an optical thickness of the transparent protective layer overlaps with a wavelength range of visible light, an iris phenomenon occurs due to the interference by multiple reflections at an interface. Also from this viewpoint, the thickness of the transparent protective layer is preferably small.

On the other hand, from the viewpoint of imparting mechanical strength and chemical strength to the transparent protective layer to increase the durability of the infrared reflecting film, the thickness of the transparent protective layer 30 is preferably 20 nm or more, more preferably 25 nm or more, further preferably 30 nm or more, particularly preferably 40 nm or more, and most preferably 45 nm or more.

A material of the transparent protective layer 30 preferably has high visible light transmittance, and excellent mechanical strength and excellent chemical strength. For example, active ray-curable or thermosetting organic resins such as fluorine-based, acryl-based, urethane-based, ester-based, epoxy-based and silicone-based resins; inorganic materials such as silicon oxide, silicon nitride, silicon oxynitride, aluminum oxide, titanium oxide, zirconium oxide and sialon (SiAlON); or organic-inorganic hybrid materials in which an organic component is chemically coupled with an inorganic component are preferably used.

When an organic material or an organic-inorganic hybrid material is employed as a material of the transparent protective layer 30, it is preferred to introduce a cross-linked structure. When the cross-linked structure is formed in the transparent protective layer 30, mechanical strength and chemical strength of the transparent protective layer are increased, and a function of protecting the infrared reflecting layer is increased. Among others, it is preferred to introduce a cross-linked structure derived from an ester compound having an acid group and a polymerizable functional group in a molecule.

Examples of the ester compound having an acid group and a polymerizable functional group in a molecule include esters of polyhydric acids such as phosphoric acid, sulfuric acid, oxalic acid, succinic acid, phthalic acid, fumaric acid and maleic acid; with a compound having, in a molecule, a hydroxyl group and a polymerizable functional group such as ethylenic unsaturated groups, silanol groups or epoxy groups. Although the ester compound may be a polyhydric

ester such as diester or triester, it is preferred that at least one acid group of a polyhydric acid is not esterified.

When the transparent protective layer 30 has a cross-linked structure derived from the above-mentioned ester compound, mechanical strength and chemical strength of the transparent protective layer are increased and the adhesion between the transparent protective layer 30 and the surface-side metal oxide layer 22 is enhanced, and therefore the durability of the infrared reflecting layer can be enhanced. Since the adhesion between the transparent protective layer 30 and the surface-side metal oxide layer 22 is enhanced, the durability of the infrared reflecting film can be enhanced by forming the transparent protective layer directly on the metal oxide layer 22 without disposing a primer layer such as an easily adhesive layer between both layers. Accordingly, the step of disposing an easily adhesive layer on the metal oxide layer 22 is omitted, and therefore the productivity of the infrared reflecting film can be increased.

Among the above ester compounds, an ester compound of phosphoric acid and an organic acid (phosphate ester compound) having a polymerizable functional group is preferred to increase the adhesion between the transparent protective layer and the metal oxide layer. It is estimated that an improvement of the adhesion between the transparent protective layer and the metal oxide layer is derived from the fact that an acid group in the ester compound exhibits high compatibility with a metal oxide, and in particular, a hydroxyl group of phosphoric acid in the phosphate ester compound has excellent compatibility with a metal oxide layer, thereby improving the adhesion.

From the viewpoint of enhancing mechanical strength and chemical strength of the transparent protective layer 30, the above ester compound preferably contains a (meth)acryloyl group as the polymerizable functional group. Further, from the viewpoint of facilitating introduction of the cross-linked structure, the above ester compound may have a plurality of functional groups in the molecule. As the above ester compound, for example, a phosphate monoester compound or a phosphate diester compound represented by the following formula (1) is suitably used. The phosphate monoester may be used in combination with the phosphate diester.

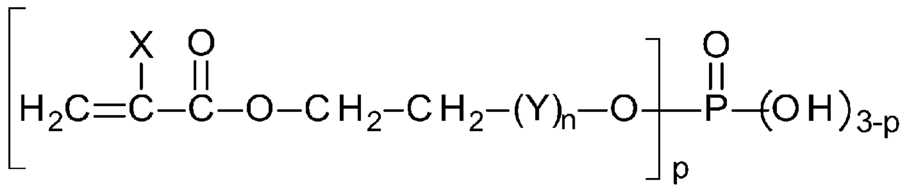

· · · (1)

In the above formula, X represents a hydrogen atom or a methyl group, and (Y) represents a $-OCO(CH_2)_5-$ group. n is 0 or 1, and p is 1 or 2.

The content of the structure derived from the above ester compound in the transparent protective layer is preferably 1 to 40 wt%, more preferably 1.5 to 30 wt%, further preferably 2 to 20 wt%, and particularly preferably 2.5 to 17.5 wt%. In a particularly preferable embodiment, the content of the structure derived from the above ester compound in the transparent protective layer is 2.5 to 15 wt%, or 2.5 to 12.5 wt%. When the content of the structure derived from the ester compound is excessively small, the effect of improving the strength or the adhesion may not be adequately achieved. On the other hand, when the content of the structure derived from the ester compound is excessively large, a curing rate during formation of the transparent protective layer may be low, resulting in a reduction of the hardness of the layer, or slip properties of the surface of the transparent protective layer may be deteriorated, resulting in a reduction of abrasion-resistance. The content of the structure derived from the ester compound in the transparent protective layer can be set to a desired range by adjusting the content of the above ester compound in a composition in formation of the transparent protective layer. In other words, when a material for forming the transparent protective layer contains a phosphate ester compound in an amount of preferably 1 to 40 wt%, more preferably 1.5 to 30 wt%, further preferably 2 to 20 wt%, and particularly preferably 2.5 to 17.5 wt% as a solid content, the structure derived from the ester compound can be introduced into the transparent protective layer in a specific amount. In a particularly preferable embodiment, the content of the phosphate ester compound in the material for forming the transparent protective layer is 2.5 to 15 wt%, or 2.5 to 12.5 wt%.

A method for forming the transparent protective layer 30 is not particularly limited. The transparent protective layer is preferably formed by dissolving, for example, an organic resin, or a curable monomer or an oligomer of an organic resin and the above-mentioned ester compound in a solvent to prepare a solution, applying the solution onto the surface-side metal oxide layer 22, removing the solvent by evaporation, and curing the rest by ultraviolet or electron irradiation or addition of heat energy.

The material of the transparent protective layer 30 may include additives such as coupling agents (silane coupling agent, titanium coupling agent, etc.), leveling agents, ultraviolet absorbers, antioxidants, heat stabilizers, lubricants, plasticizers, coloring inhibitors, flame retarders and antistatic agents in addition to the above-mentioned organic materials, inorganic materials and ester compounds. The contents of these additives can be appropriately adjusted to an extent which does not impair the object of the present invention.

As described above, by depositing the surface-side metal oxide layer 22 under the specific conditions, the adhesion between the metal layer 25 and the surface-side metal oxide layer is enhanced, and by forming, on the surface-side metal oxide layer, the transparent protective layer 30 having a cross-linked structure derived from a specific ester compound, the adhesion between the infrared reflecting layer 20 and the transparent protective layer is enhanced. Thus, according to the present invention, the adhesion between the respective layers can be increased and the durability can be improved without increasing the number of stacked layers, and therefore an infrared reflecting film having excellent durability can be attained even when the thickness of the transparent protective layer 30 is 200 nm or less. Further, as described above, the durability is also increased by employing a silver alloy containing metal such as Pd or the like as the metal layer 25, and therefore the thickness of the transparent protective layer can be reduced while maintaining the durability.

[Stacking Configuration of Infrared Reflecting Film]

As described above, the infrared reflecting film 100 of the present invention includes the infrared reflecting layer 20 having the metal layer 25 and the surface-side metal oxide layer 22, and the transparent protective layer 30 on one principal surface of the transparent film substrate 10. In addition, the infrared reflecting layer 20 preferably has the substrate-side metal oxide layer 21 between the transparent film substrate 10 and the metal layer 25.

A surface opposite to the infrared reflecting layer 20 of the transparent film substrate 10 may be provided with an adhesive layer or the like to be used for bonding the infrared reflecting film to window glass or the like. As the adhesive layer, an adhesive having high visible light transmittance and a small difference in refractive index with the transparent film substrate 10 is suitably used. For example, an acryl-based pressure sensitive adhesive is suitable as a material of the adhesive layer provided for the transparent film substrate, since it has excellent optical transparency, exhibits appropriate wettability, cohesive property, and adhesion properties, and is excellent in weatherability and heat resistance.

The adhesive layer preferably has high visible light transmittance and low ultraviolet transmittance. The degradation of the infrared reflecting layer caused by ultraviolet rays of the sunlight or the like can be suppressed by reducing the ultraviolet transmittance of the adhesive layer. From the viewpoint of reducing the ultraviolet transmittance of the adhesive layer, the adhesive layer preferably contains an ultraviolet absorber. The degradation of the infrared reflecting layer caused by ultraviolet rays from the outdoors can also be suppressed by using a transparent film substrate containing an ultraviolet absorber. An exposed surface of the adhesive layer is preferably temporarily attached with a separator to be covered for the purpose of preventing the contamination of the exposed surface until the infrared reflecting film is put into practical use. This can prevent the contamination of the exposed surface of the adhesive layer due to contact with external during usual handling.

[Characteristic of Infrared Reflecting Film]

In the infrared reflecting film of the present invention, a normal emittance measured from the transparent protective layer 30 side is preferably 0.20 or less, more preferably 0.15 or less, further preferably 0.12 or less, and particularly preferably 0.10 or less. The change in the emissivity of the infrared reflecting film immersed in a 5 wt% aqueous solution of sodium chloride for 5 days is preferably 0.02 or less, and more preferably 0.01 or less. The visible light transmittance of the infrared reflecting film is preferably 63% or more, more preferably 65% or more, further preferably 67% or more, and particularly preferably 68% or more. In the present invention, it is possible to manufacture, at a high level of productivity, an infrared reflecting film having the above-mentioned visible light transmittance, normal emittance and durability by depositing a surface-side metal oxide layer 22 composed of ZTO on a metal layer 25 under the specific conditions.

In the infrared reflecting film, hues of the transmitted light and the reflected light are preferably neutral. It is possible to evaluate whether the hue is close to a neutral or not from a value of chroma c*. The c* of the transmitted light of the infrared reflecting film is preferably 10 or less, more preferably 8 or less, and further preferably 5 or less. The c* of the reflected light of the infrared reflecting film is preferably 10 or less, more preferably 8 or less, further preferably 5 or less, and particularly preferably 2 or less. The c* can be calculated from the following formula based on the hues (a* and b*) of the transmitted light and the reflected light measured according to JIS Z 8729.

$$c^* = \sqrt{{a^*}^2 + {b^*}^2}$$

[Usage]

The infrared reflecting film of the present invention is preferably used for being bonded to windows of buildings,

vehicles or the like, transparent cases for botanical companions or the like, or showcases of freezing or cold storage, to improve the effects of cooling /heating and to prevent rapid changes in temperature. As schematically shown in FIG. 2, the infrared reflecting film 100 of the present invention transmits visible light (VIS) from the outdoors to introduce the light to the interior, and reflects near-infrared rays (NIR) from the outdoors at the infrared reflecting layer 20. Since heat flow from the outdoors to the interior resulting from sunlight is suppressed (heat shielding effect is exerted) by the reflection of near-infrared rays, efficiency of the air conditioning in summer can be increased. Moreover, when a material having low far-infrared ray absorption is used as the transparent protective layer 30, indoor far-infrared rays (FIR) emitted from a heating appliance 80 is reflected toward an indoor by the infrared reflecting layer 20, and thereby a heat insulating effect is exerted and efficiency of heating in winter can be increased.

EXAMPLE

The present invention will be described more specifically below by showing examples, but the present invention is not limited to these examples.

[Measuring Methods Used in Examples and Comparative Examples]

<Thickness of Each Layer>

A thickness of each layer constituting the infrared reflecting layer was determined by machining a sample by a focused ion beam (FIB) method using a focused ion beam machining observation device (manufactured by Hitachi, Ltd., trade name "FB-2100"), and observing a cross-section of the sample using a field emission transmission electron microscope (manufactured by Hitachi, Ltd., trade name "HF-2000"). Thicknesses of the hard coat layer and the transparent protective layer formed on the substrate were determined by calculation from an interference pattern of reflected light of visible light in allowing light to enter from a measuring object side by using an instantaneous multi-photometric system (manufactured by Otsuka Electronics Co., Ltd., trade name "MCPD3000"). When the thickness of the transparent protective layer is small and observation of an interference pattern of visible light region is difficult (thickness about 150 nm or less), the thickness was determined from the observation by a transmission electron microscope as with each layer of the infrared reflecting layer described above.

<Volume Resistivity of Target>

Surface resistance $\rho s(\Omega/sq)$ at the target surface was measured using a resistivity meter (manufactured by Mitsubishi Chemical Analytech Co., Ltd., trade name "Loresta"), and volume resistivity pv was calculated from a product of surface resistance ps and the thickness.

<Normal Emittance>

Infrared rays were irradiated from the protective layer side using a Fourier transform infrared spectrophotometer (FT-IR) (manufactured by Varian Inc.) equipped with angle-variable accessories, and the normal reflectance of infrared rays in a wavelength range of 5 $\mu$m to 25 $\mu$m was measured, and then the normal emittance was determined according to JIS R 3106-2008 (Testing method on transmittance, reflectance and emittance of flat glasses and evaluation of solar heat gain coefficient).

<Visible Light Transmittance, Visible Light Reflectance and Hue>

The visible light transmittance, the visible light reflectance and the hue were measured by using a spectral photometer (trade name "U-4100" manufactured by Hitachi High-Technologies Corporation). The visible light transmittance and the visible light reflectance were measured according to JIS A 5759-2008 (Adhesive films for glazings). In measurement of the visible light reflectance and the hue, a surface on a transparent film substrate side of an infrared reflecting film was bonded to a glass plate with a thickness of 3 mm with a pressure sensitive adhesive layer interposed therebetween to form a sample for measurement.

The visible light reflectance was determined by allowing light to enter at an incident angle of 5° from the surface on a glass plate side of the sample for measurement, and measuring an absolute reflectance in a wavelength range of 380 nm to 780 nm. The visible light transmittance and the visible light reflectance were respectively calculated as a weighted average multiplied by a weighting factor of JIS A 5759-2008. The hue was determined by allowing light to enter from the surface on a glass plate side of the sample for measurement, measuring spectral transmittance/reflectance (field of view of 2-degree, standard light source: D65), and calculating according to JIS Z 8729. The chroma c* was

calculated from the resulting hue (a* and b*).

<Salt Water Resistance Test>

A surface on a transparent film substrate side of an infrared reflecting film was bonded to a glass plate with a size of 3 cm x 3 cm with a pressure sensitive adhesive layer having a thickness of 25 μm interposed therebetween to form a sample to be used for a test. This sample was immersed in a 5 wt% aqueous solution of sodium chloride, a container containing the sample and the aqueous solution of sodium chloride was placed in a drier at 50°C, and changes in emissivity and changes in appearance were checked 5 days later and 10 days later and rated according the following criteria.

A: After 10 days immersion, there was no change in the appearance and change in the emissivity was 0.02 or less
B: After 5 days immersion, there is no change in the appearance and change in the emissivity is 0.02 or less, but after 10 days immersion, change in the appearance was found
C: After 5 days immersion, change in the appearance was found, but change in the emissivity was 0.02 or less
D: After 5 days immersion, change in the appearance was found, and change in the emissivity was 0.02 or more

<Adhesion Test>

A surface on a transparent film substrate side of an infrared reflecting film cut into a size of 12 cm x 3 cm was bonded to an aluminum plate with a pressure sensitive adhesive layer having a thickness of 25 μm interposed therebetween to form a sample to be used for a test. Using GAKUSHIN-type COLOR FASTNESS RUBBING TESTER (manufactured by YASUDA SEIKI SEISAKUSHO, LTD.), a surface on a transparent protective layer side of the infrared reflecting film on the aluminum plate was scrubbed one-thousand times in reciprocatory fashion within a range of length of 10 cm with an alcohol-type wet tissue (manufactured by Kohnan Shoji Co., Ltd.) while applying a load of 500 g. The presence or absence of peeling at the interface between the metal oxide layer and the metal layer in the tested sample was visually observed, and the sample in which peeling at the interface was not found was rated as "A", and the sample in which peeling at the interface was found was rated as "B".

[Example 1]

(Formation of Hard Coat Layer on Substrate)

An acryl-based ultraviolet-curable hard coat layer (manufactured by Nippon Soda Co., Ltd., NH2000G) was formed in a thickness of 2 μm on one surface of a polyethylene terephthalate film (manufactured by Toray Industries Inc., trade name "Lumirror U48", visible light transmittance 93%) having a thickness of 50 μm. Specifically, a hard coat solution was applied with a gravure coater, dried at 80°C, and irradiated with ultraviolet rays of accumulated light quantity of 300 $mJ/cm^2$ by an ultra high pressure mercury lamp to be cured.

(Formation of Infrared Reflecting Layer)

An infrared reflecting layer was formed on a hard coat layer of the polyethylene terephthalate film substrate by using a roll-to-roll sputtering apparatus. Specifically, by a DC magnetron sputtering method, a substrate-side metal oxide layer composed of a zinc-tin composite oxide (ZTO) and having a thickness of 30 nm, a metal layer composed of an Ag-Pd alloy and having a thickness of 15 nm, and a surface-side metal oxide layer composed of ZTO and having a thickness of 30 nm were formed sequentially. A target formed by sintering composition consisting of zinc oxide, tin oxide and a metal zinc powder at a weight ratio of 8.5 : 83 : 8.5 was used for forming the substrate-side metal oxide layer and the surface-side metal oxide layer, and sputtering was performed under conditions of a power density: 2.67 $W/cm^2$, a process pressure: 0.4 Pa, and a substrate temperature: 80°C. In this case, the amount of gas introduced into the sputtering chamber was adjusted so that a ratio between Ar and $O_2$ is 98 : 2 (volume ratio). A metal target containing silver and palladium in a weight ratio of 96.4 : 3.6 was used for forming the metal layer.

(Formation of Transparent Protective Layer)

On the infrared reflecting layer, a protective layer composed of a fluorine-based ultraviolet-curable resin having a cross-linked structure derived from a phosphate ester compound, was formed in a thickness of 60 nm. Specifically, a solution prepared by adding 5 parts by weight of a phosphate ester compound (manufactured by Nippon Kayaku Co., Ltd., trade name "KAYAMER PM-21") to 100 parts by weight of a solid content of a fluorine-based hard coat resin solution

(manufactured by JSR Corporation, trade name "JUA204"), was applied by using an applicator, dried at 60°C for 1 minute, and irradiated with ultraviolet rays of accumulated light quantity of 400 mJ/cm$^2$ by an ultra high pressure mercury lamp in a nitrogen atmosphere to be cured. The phosphate ester compound used here is a mixture of a phosphate monoester compound (compound represented by the formula (1), wherein X is a methyl group, n = 0, and p = 1) having one acryloyl group in a molecule and a phosphate diester compound (compound represented by the formula (1), wherein X is a methyl group, n = 0, and p = 2) having two acryloyl groups in a molecule.

[Examples 2A and 2B]

The amount of gas introduced into the sputtering chamber in deposition of the substrate-side metal oxide layer was changed so that a volume ratio between Ar and $O_2$ is 90 : 10 (Example 2A) and a volume ratio between Ar and $O_2$ is 95 : 5 (Example 2B). The amount of Ar gas/$O_2$ gas introduced in deposition of the surface-side metal oxide layer was set so that a volume ratio between Ar and $O_2$ is 98 : 2 as with Example 1. Infrared reflecting films were prepared in the same manner as in Example 1 except for changing the amount of gas introduced in deposition of the substrate-side metal oxide layer as described above.

[Example 3]

As the sputtering target for forming the substrate-side metal oxide layer and the surface-side metal oxide layer, a target formed by sintering composition consisting of zinc oxide, tin oxide, and a metal zinc powder at a weight ratio of 19 : 73 : 8 was used. In the same manner as in Example 1 except for this, an infrared reflecting film was prepared.

[Example 4]

As the sputtering target for forming the substrate-side metal oxide layer and the surface-side metal oxide layer, a target formed by sintering composition consisting of zinc oxide, tin oxide, and a metal zinc powder at a weight ratio of 16 : 82 : 2 was used. In the same manner as in Example 1 except for this, an infrared reflecting film was prepared.

[Example 5]

As the sputtering target for forming the substrate-side metal oxide layer and the surface-side metal oxide layer, a target formed by sintering composition consisting of zinc oxide, tin oxide, and a metal zinc powder at a weight ratio of 25.5 : 66.5 : 8 was used. In the same manner as in Example 1 except for this, an infrared reflecting film was prepared.

[Example 6]

As the sputtering target for forming the substrate-side metal oxide layer and the surface-side metal oxide layer, a target formed by sintering composition without containing zinc oxide, and consisting of tin oxide and a metal zinc powder at a weight ratio of 85 : 15, was used In the same manner as in Example 1 except for this, an infrared reflecting film was prepared.

[Example 7]

As the sputtering target for forming the substrate-side metal oxide layer and the surface-side metal oxide layer, a target formed by sintering composition without containing zinc oxide, and consisting of tin oxide and a metal zinc powder at a weight ratio of 92 : 8, was used. In the same manner as in Example 1 except for this, an infrared reflecting film was prepared.

[Examples 8 to 10]

Infrared reflecting films were prepared in the same manner as in Example 1 except for changing the thickness of each of the transparent protective layers as shown in Table 1.

[Example 11]

In the formation of the metal layer, a metal target containing silver and gold at a weight ratio of 90 : 10 in place of an Ag-Pd alloy, was used to form a metal layer composed of an Ag-Au alloy. In the same manner as in Example 1 except for this, an infrared reflecting film was prepared.

[Comparative Example 1]

The amount of gas introduced into the sputtering chamber in deposition of each of the substrate-side metal oxide layer and the surface-side metal oxide layer was changed so that a volume ratio between Ar and $O_2$ is 90 : 10. In the same manner as in Example 5 except for this, an infrared reflecting film was prepared.

[Comparative Example 2]

As the sputtering target for forming the substrate-side metal oxide layer and the surface-side metal oxide layer, a target formed by sintering composition without containing metal powder, and consisting of zinc oxide and tin oxide at a weight ratio of 19 : 81, was used. Under the same conditions as in Example 1 except for this, sputtering deposition was tried, but discharge at a DC power source did not occur and a metal oxide layer could not be deposited.

[Comparative Example 3]

As the sputtering target for forming the substrate-side metal oxide layer and the surface-side metal oxide layer, a target formed by sintering composition without containing both zinc oxide and metal zinc powder, and consisting of tin oxide and metal tin at a weight ratio of 92 : 8, was used. Under the same conditions as in Example 1 except for this, sputtering deposition was tried, but discharge at a DC power source did not occur and a metal oxide layer could not be deposited.

[Comparative Example 4]

In Comparative Example 4, zinc oxides were respectively deposited in a thickness of 30 nm in place of ZTO as the substrate-side and the surface-side metal oxide layers. As the sputtering target for forming the substrate-side metal oxide layer and the surface-side metal oxide layer, a target formed by sintering composition without containing both tin oxide and metal tin, and consisting of zinc oxide and metal zinc at a weight ratio of 90 : 10, was used. In the same manner as in Example 1 except for this, an infrared reflecting film was prepared.

[Comparative Example 5]

In Comparative Example 5, indium tin oxides (ITOs) were respectively deposited in a thickness of 30 nm in place of ZTO as the substrate-side and the surface-side metal oxide layers. A target formed by sintering composition consisting of indium oxide and tin oxide at a weight ratio of 90 : 10 was used for deposition of the ITO. In the same manner as in Example 1 except for this, an infrared reflecting film was prepared.

[Comparative Example 6]

In Comparative Example 6, titanium oxides ($TiO_2$) were respectively deposited in a thickness of 30 nm in place of ZTO as the substrate-side and the surface-side metal oxide layers. As the sputtering target for forming the substrate-side metal oxide layer and the surface-side metal oxide layer, a target (manufactured by AGC Ceramics Co., Ltd., TXO Target) formed by sintering composition consisting of titanium oxide and a metal titanium powder was used. The amount of gas introduced into the sputtering chamber in deposition of each of these metal oxide layers was set so that a volume ratio between Ar and $O_2$ is 94 : 6. In the same manner as in Example 5 except for this, an infrared reflecting layer was formed. In Comparative Example 6, the transparent protective layer was not formed on the infrared reflecting layer.

[Comparative Example 7]

In Comparative Example 7, indium zinc oxides (IZOs) were respectively deposited in a thickness of 30 nm in place of ZTO as the substrate-side and the surface-side metal oxide layers. A target formed by sintering composition consisting of indium oxide and zinc oxide at a weight ratio of 90 : 10, was used for deposition of the IZO. In the same manner as in Example 1 except for this, an infrared reflecting film was prepared.

[Comparative Example 8]

In the formation of the infrared reflecting layer, a Ni-Cr alloy layer was deposited in a thickness of 3 nm between the substrate-side metal oxide layer and the metal layer, and between the metal layer and the surface-side metal oxide layer by a sputtering method using a metal target containing nickel and chromium at a weight ratio of 80 : 20 to form an

infrared reflecting layer having a five-layer structure of ZTO/Ni-Cr/Ag-Pd/Ni-Cr/ZTO. In the same manner as in Example 1 except for this, an infrared reflecting film was prepared.

[Evaluation]

Table 1 shows evaluation results of tests on the material of the metal oxide layer in the infrared reflecting film, the composition consisting of the target or the like used for deposition, the amount of oxygen introduced during deposition of the metal oxide layer, the thickness of the transparent protective layer, the emissivity of the infrared reflecting film, the visible light transmittance, the adhesion and the salt water resistance of each of Examples and Comparative Examples. Further, the transmittance and the reflectance of the infrared reflecting film, and hues of transmitted light and reflected light of Example 1, and Examples 2A and 2B are shown in Table 2.

[Table 1]

| | metal oxide layer | | | | | metal layer | protective layer | infrared reflecting film | | | |
|---|---|---|---|---|---|---|---|---|---|---|---|
| | material | target | | | oxygen introduction amount | | | | | | |
| | | Composition (weight ratio) | Metallic atom content ratio (atomic ratio) | volume resistivity (mΩ·cm) | substrate-side/ surface-side (vol%) | component | thickness (nm) | emissivity | visible light transmittance (%) | adhesion | salt water resistance |
| Example 1 | ZTO | $ZnO:SnO_2:Zn$= 8.5:83:8.5 | Zn:Sn=30:70 | 79 | 2/2 | Ag-Pd | 60 | 0.07 | 69.1 | A | A |
| Example 2A | ZTO | $ZnO:SnO_2:Zn$= 8.5:83:8.5 | Zn:Sn=30:70 | 79 | 10/2 | Ag-Pd | 60 | 0.07 | 68.7 | A | A |
| Example 2B | ZTO | $ZnO:SnO_2:Zn$= 8.5:83:8.5 | Zn:Sn=30:70 | 79 | 5/2 | Ag-Pd | 60 | 0.07 | 67.6 | A | A |
| Example 3 | ZTO | $ZnO:SnO_2:Sn$= 19:73:8 | Zn:Sn=30:70 | 130 | 2/2 | Ag-Pd | 60 | 0.07 | 67.5 | A | A |
| Example 4 | ZTO | $ZnO:SnO_2:Zn$= 16:82:2 | Zn:Sn=30:70 | 316 | 2/2 | Ag-Pd | 60 | 0.07 | 70.1 | A | B |
| Example 5 | ZTO | $ZnO:SnO_2:Zn$= 25.5:66.5:8 | Zn:Sn=50:50 | 18 | 2/2 | Ag-Pd | 60 | 0.06 | 69.5 | A | A |
| Example 6 | ZTO | $ZnO:SnO_2:Zn$= 0:85:15 | Zn:Sn=29:71 | 39.5 | 2/2 | Ag-Pd | 60 | 0.07 | 67.7 | A | A |
| Example 7 | ZTO | $ZnO:SnO_2:Zn$= 0:92:8 | Zn:Sn=17:83 | 380 | 2/2 | Ag-Pd | 60 | 0.07 | 68.2 | A | A |
| Example 8 | ZTO | $ZnO:SnO_2:Zn$= 8.5:83:8.5 | Zn:Sn=30:70 | 79 | 2/2 | Ag-Pd | 40 | 0.07 | 69.7 | A | A |
| Example 9 | ZTO | $ZnO:SnO_2:Zn$= 8.5:83:8.5 | Zn:Sn=30:70 | 79 | 2/2 | Ag-Pd | 150 | 0.07 | 59.5 | A | A |
| Example 10 | ZTO | $ZnO:SnO_2:Zn$= 8.5:83:8.5 | Zn:Sn=30:70 | 79 | 2/2 | Ag-Pd | 200 | 0.08 | 68.2 | A | A |

(continued)

| | metal oxide layer | | | | | metal layer | protective layer | infrared reflecting film | | | |
|---|---|---|---|---|---|---|---|---|---|---|---|
| | material | target | | | oxygen introduction amount | | | | | | |
| | | Composition (weight ratio) | Metallic atom content ratio (atomic ratio) | volume resistivity (mΩ·cm) | substrate-side/ surface-side (vol%) | component | thickness (nm) | emissivity | visible light transmittance (%) | adhesion | salt water resistance |
| Example 11 | ZTO | $ZnO:SnO_2:Zn=$ 8.5:83:8.5 | Zn:Sn=30:70 | 79 | 2/2 | Ag-Au | 60 | 0.06 | 70.1 | A | A |
| Comparative Example 1 | ZTO | $ZnO:SnO_2:Zn=$ 25.5:66.5:8 | Zn:Sn=50:50 | 18 | 10/10 | Ag-Pd | 60 | 0.07 | 70.6 | B | D |
| Comparative Example 2 | ZTO | $ZnO:SnO_2=19:81$ | Zn:Sn=30:70 | 52000 | 2/2 | Ag-Pd | 60 | - | | | |
| Comparative Example 3 | $SnO_2$ | $ZnO/SnO_2:Sn=$ 0:92:8 | Sn=100 | 46900 | 2/2 | Ag-Pd | 60 | - | | | |
| Comparative Example 4 | ZnO | $ZnO:SnO_2:Zn=$ 90:0:10 | Zn=100 | 23 | 2/2 | Ag-Pd | 60 | 0.06 | 60.1 | A | D |
| Comparative Example 5 | ITO | $In_2O_3:SnO_2=90:10$ | In:Sn=91:9 | 0.12 | 2/2 | Ag-Pd | 60 | 0.08 | 62.0 | A | D |
| Comparative Example 6 | TiOx | TiOx+Ti=100 | Ti=100 | 140 | 6/6 | Ag-Pd | - | 0.67 | N.D. | | |
| Comparative Example 7 | IZO | $In_2O_3:ZnO=90:10$ | In:Zn=84:16 | 0.12 | 2/2 | Ag-Pd | 60 | 0.06 | 68.9 | A | C |
| Comparative Example 8 | ZTO | $ZnO:SnO_2:Zn=$ 25.5:66.5:8 | Zn:Sn=50:50 | 18 | 10/10 | Ni-Cr/Ag-Pd /Ni-Cr | 60 | 0.07 | 53.6 | A | B |

N.D: not determined

[Table 2]

| | oxygen introduction amount during deposition | protective layer thickness (nm) | Optical properties | | | | | | | |
|---|---|---|---|---|---|---|---|---|---|---|
| | | | transmitted light | | | | reflected light | | | |
| | substrate-side / surface-side (vol%) | | transmittance (%) | a* | b* | c* | reflectance (%) | a* | b* | c* |
| Example 1 | 2/2 | 60 | 69.1 | -2.7 | 8.4 | 8.8 | 14.0 | -0.6 | 7.9 | 7.9 |
| Example 2A | 10/2 | 60 | 68.7 | -1.6 | 4.0 | 4.3 | 17.8 | -1.0 | 1.0 | 1.4 |
| Example 2B | 5/2 | 60 | 67.6 | -1.8 | 6.6 | 6.8 | 15.8 | -1.0 | 4.2 | 4.3 |

In all of Examples in which a target formed by sintering zinc oxide and/or tin oxide and a metal powder was used as a target in deposition of a metal oxide layer on a metal layer and the oxygen introduction amount was 8 vol% or less, the adhesion between the metal layer and the metal oxide layer was high, and salt water resistance was good. Further, the infrared reflecting substrates of Examples 1 to 8 had high visible light transmittance and excellent transparency, and further had small emissivity and can exert a high heat insulating effect.

In Example 2A and Example 2B, the oxygen introduction amount in deposition of a metal oxide layer on a side of the transparent film substrate were increased to 10 vol% and 5 vol%, respectively, the adhesion was good as with other Examples. On the other hand, in Comparative Example 1 in which the oxygen introduction amount in deposition of a metal oxide layer on a metal layer was increased to 10 vol%, deterioration of the adhesion and the durability was confirmed. It was found from these results that in the present invention, the adhesion and the durability are improved by depositing a ZTO metal oxide layer on a metal layer under the specific conditions.

Further, as shown in Table 2, in Example 2A and Example 2B, a value of the hue is low, and the hues of the transmitted light and the reflected light are neutralized compared with Example 1.

It was found from these results that an infrared reflecting film can be attained which has excellent durability, and has excellent visibility because of neutralization of the hues of the transmitted light and the reflected light, when the oxygen concentration in deposition of the substrate-side metal oxide layer is made higher than that in deposition of the surface-side metal oxide layer.

In Comparative Example 2 in which an oxide target not containing metal was used and Comparative Example 3 in which tin oxide/tin sintered target having high resistivity was used, DC sputtering deposition could not be performed. Further, as is apparent from a comparison between Comparative Example 3 and Comparative Example 4, tin oxide is low in the electrical conductivity than zinc oxide, and in general, it is difficult to deposit a tin-rich ZTO by DC sputtering. It was found from these results that in the present invention, the electrical conductivity of the target is increased by using a target formed by sintering a metal oxide and a metal, and therefore a tin-rich ZTO metal oxide layer having excellent durability can be deposited at a high deposition rate by DC sputtering.

In Comparative Examples 4, 5 and 7 in which metal oxides other than ZTO were deposited, deterioration of the durability was found. On the other hand, in Comparative Example 6 in which a target formed by sintering titanium oxide and a metal titanium powder was used, the emissivity was largely increased even though the transparent protective layer was not formed. This is thought to be due to the fact that a silver layer serving as an underlay was deteriorated by oxidation in deposition of a titanium oxide layer.

In Comparative Example 8 in which the Ni-Cr alloy layer was deposited as a primer layer for increasing the adhesion between the metal oxide layer and the metal layer, the adhesion was good, but a significant reduction of the visible light transmittance was confirmed.

It was found from the above-mentioned results that among various metal oxides, ZTO has a high function as a protective layer to the metal layer composed mainly of silver. Further, it was found that in the present invention, since a specific target is used for depositing the ZTO metal oxide layer and the oxygen introduction amount is adjusted, it is possible to manufacture, at a high level of productivity, an infrared reflecting film which is excellent in transparency, heat insulating properties, durability, and visibility.

DESCRIPTION OF REFERENCE CHARACTERS

| | |
|---|---|
| 100: | infrared reflecting film |
| 10: | transparent film substrate |
| 20: | infrared reflecting layer |
| 21, 22: | metal oxide layer |
| 25: | metal layer |
| 30: | protective layer |
| 60: | adhesive layer |

## Claims

1. A method for manufacturing an infrared reflecting film including a metal layer, a surface-side metal oxide layer, and a transparent protective layer in this order on a transparent film substrate,
the metal layer being a layer composed mainly of silver, and the surface-side metal oxide layer being a composite metal oxide layer containing tin oxide and zinc oxide,
the manufacturing method comprising: a metal layer forming step of depositing the metal layer on a transparent film substrate; a surface-side metal oxide layer forming step of depositing the surface-side metal oxide layer by DC sputtering on the metal layer so as to be in direct contact with the metal layer; and a transparent protective layer forming step of forming the transparent protective layer on the surface-side metal oxide layer, in this order, wherein in the surface-side metal oxide layer forming step, a sputtering target used for DC sputtering contains zinc atoms and tin atoms, and is formed by sintering a metal powder and at least one metal oxide among zinc oxide and tin oxide, and
an inert gas and an oxygen gas are introduced into a sputtering chamber and an oxygen concentration in the gas introduced into the sputtering chamber is 8 vol% or less.

2. The method for manufacturing an infrared reflecting film according to claim 1, wherein a metal powder used for a formation of the sputtering target for forming the surface-side metal oxide layer contains metal zinc or metal tin.

3. The method for manufacturing an infrared reflecting film according to claim 2, wherein a total of contents of the metal zinc and the metal tin used for the formation of the sputtering target for the formation of the surface-side metal oxide layer, is 0.1 to 20 wt%.

4. The method for manufacturing an infrared reflecting film according to any one of claims 1 to 3, wherein a ratio between zinc atoms and tin atoms, respectively contained in the sputtering target for the formation of the surface-side metal oxide layer, is in a range of 10 : 90 to 60 : 40 in terms of an atomic ratio.

5. The method for manufacturing an infrared reflecting film according to any one of claims 1 to 4 further comprising, prior to the metal layer forming step, a substrate-side metal oxide layer forming step of depositing the substrate-side metal oxide layer by DC sputtering on the transparent film substrate, the substrate-side metal oxide layer being composed of a composite metal oxide containing tin oxide and zinc oxide, wherein
in the substrate-side metal oxide layer forming step, a sputtering target used for DC sputtering contains zinc atoms and tin atoms, and is formed by sintering a metal powder and at least one metal oxide among zinc oxide and tin oxide, and
in the substrate-side metal oxide layer forming step, an oxygen concentration in the gas introduced into the sputtering chamber is higher than that in the gas introduced into the sputtering chamber in the surface-side metal oxide layer forming step.

6. The method for manufacturing an infrared reflecting film according to claim 5, wherein a metal powder used for a formation of the sputtering target for forming the substrate-side metal oxide layer contains metal zinc or metal tin.

7. The method for manufacturing an infrared reflecting film according to claim 6, wherein a total of contents of the metal zinc and the metal tin used for the formation of the sputtering target for the formation of the substrate-side metal oxide layer, is 0.1 to 20 wt%.

**8.** The method for manufacturing an infrared reflecting film according to any one of claims 5 to 7, wherein a ratio between zinc atoms and tin atoms, respectively contained in the sputtering target for the formation of the substrate-side metal oxide layer, is in a range of 10 : 90 to 60 : 40 in terms of an atomic ratio.

**9.** The method for manufacturing an infrared reflecting film according to any one of claims 1 to 8, wherein in the transparent protective layer forming step, the protective layer is formed so as to be in direct contact with the metal oxide layer.

FIG. 1

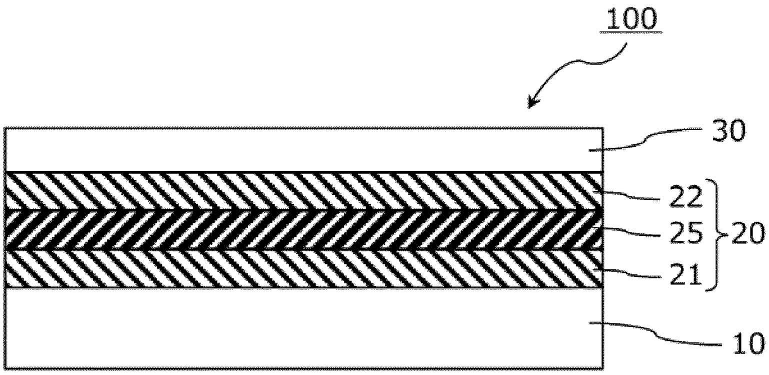


FIG. 2

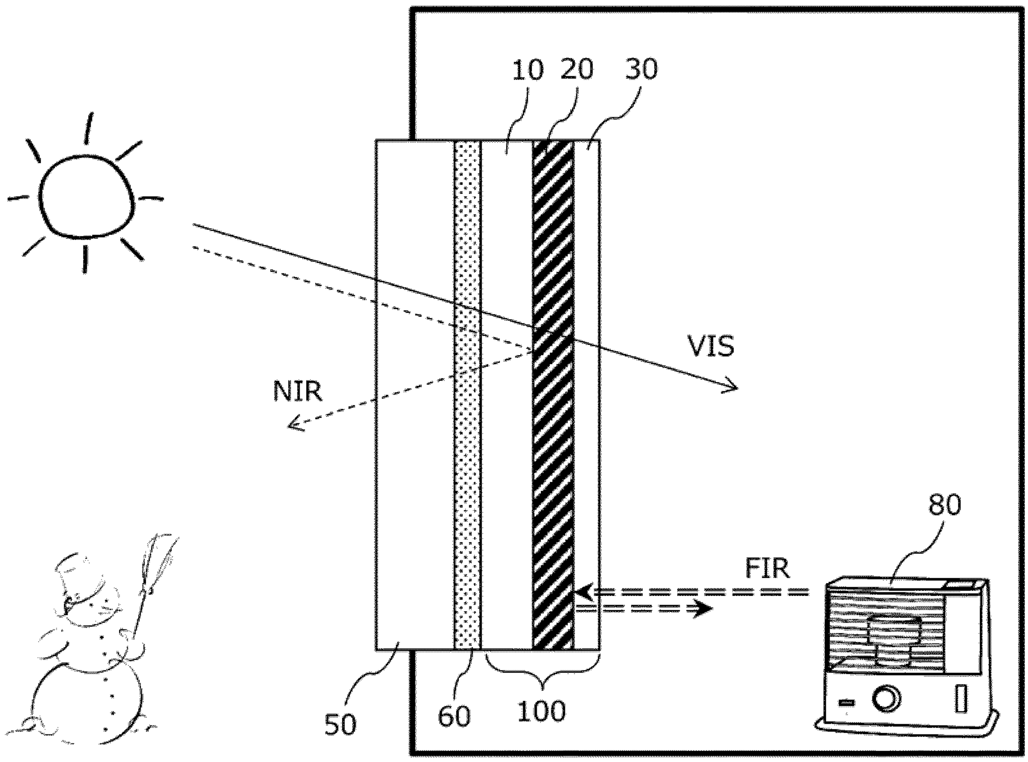

**INTERNATIONAL SEARCH REPORT**

International application No.
PCT/JP2014/052159

A. CLASSIFICATION OF SUBJECT MATTER
*G02B5/26*(2006.01)i, *B32B9/00*(2006.01)i, *B32B15/08*(2006.01)i, *C23C14/06*(2006.01)i, *C23C14/34*(2006.01)i

According to International Patent Classification (IPC) or to both national classification and IPC

B. FIELDS SEARCHED

Minimum documentation searched (classification system followed by classification symbols)
G02B5/26, B32B9/00, B32B15/08, C23C14/06, C23C14/34

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-533565 A (PPG Industries Ohio, Inc.), 08 October 2002 (08.10.2002), paragraphs [0013] to [0026]; fig. 1 to 2<br>& US 6398925 B1 & EP 1140721 A<br>& WO 2000/037384 A1 & AU 2181200 A<br>& NO 20012974 A & BR 9917073 A<br>& CZ 20011943 A & CA 2352845 A<br>& AU 757917 B & AT 260874 T<br>& DK 1140721 T & PT 1140721 E<br>& ES 2217875 T & TW 249582 B | 1-9 |
| Y | JP 2007-314364 A (Sumitomo Metal Mining Co., Ltd.), 06 December 2007 (06.12.2007), paragraphs [0002], [0007], [0038], [0056], [0073]; table 1<br>(Family: none) | 1-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 March, 2014 (24.03.14) | 01 April, 2014 (01.04.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/052159

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-502259 A (PPG Industries Ohio, Inc.), 21 January 2003 (21.01.2003), paragraphs [0009] to [0061]<br>& JP 4836376 B & JP 2003-526732 A<br>& JP 2011-184296 A & JP 5101763 B<br>& US 6833194 B1 & US 6899953 B1<br>& US 2005/0129863 A1 & US 2005/0155695 A1<br>& EP 1194385 A & EP 1080245 A<br>& WO 2000/076930 A1 & WO 1999/058736 A2<br>& AU 5467300 A & CA 2374768 A<br>& AU 764332 B | 1-9 |
| A | JP 2-009731 A (PPG Industries, Inc.), 12 January 1990 (12.01.1990), page 4, upper right column, line 19 to page 7, upper left column, line 12<br>& US 4834857 A & US 4902580 A<br>& EP 339274 A1 & NO 891207 A<br>& NZ 228159 A & AU 3232189 A<br>& ES 2051316 T & FI 891527 A<br>& CA 1335887 A & DK 157189 A<br>& HK 1006834 A & ZA 8901665 A<br>& AT 101588 T | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011109306 A
- JP 1301537 A